(19)

Europäisches
Patentamt
European
Patent Office
Office européen
des brevets

(11) **EP 1 868 001 A1**

(12) **EUROPEAN PATENT APPLICATION**

(43) Date of publication:
**19.12.2007 Bulletin 2007/51**

(51) Int Cl.:
**G01R 23/16** *(2006.01)*

(21) Application number: **06115309.4**

(22) Date of filing: **12.06.2006**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(71) Applicant: **Ali Corporation
114, Taipei (TW)**

(72) Inventor: **Zhao, Dan
Hsuhuei District, Shanhai City, (CN)**

(74) Representative: **Kewitz, Ansgar
2K Patentanwälte, Kewitz & Kollegen,
Partnerschaft,
Corneliusstrasse 18
60325 Frankfurt am Main (DE)**

Remarks:
Amended claims in accordance with Rule 137 (2)
EPC.

(54) **Bandwith and frequency offset estimation method**

(57)    The invention relates to a bandwidth and frequency offset estimation method, and in particular, to a bandwidth and frequency offset estimation method based on a spectrum shape. A bandwidth and frequency offset estimation method comprises: comparing sample values of an input signal with at least one threshold value; estimating a plurality of positive and/or negative frequencies corresponding to different threshold values; and determining a bandwidth and a frequency offset according to the plurality of positive and/or negative frequencies.

FIG. 4

EP 1 868 001 A1

**Description**

**BACKGROUND OF THE INVENTION**

**Field of the Invention**

The invention relates to a bandwidth and frequency offset estimation method, and in particular, to a bandwidth and frequency offset estimation method based on a spectrum shape.

**Description of the Related Art**

In recent years, a need for estimating bandwidth (or symbol rate) and frequency offset in a communication system, especially in single-carrier communication system, has arisen. The receiver in the communication system can estimate the bandwidth and frequency offset by sweeping (trying) every possibility in a predetermined range. The sweeping method may, however, take a long convergence time since the swept bandwidth and frequency must be correct at the same time.

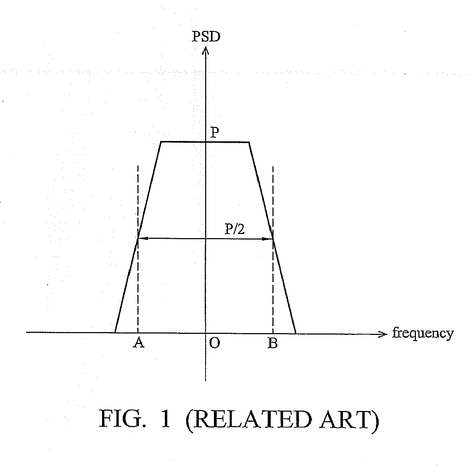

The receiver can also estimate the bandwidth and frequency offset by utilizing a power density spectrum (PDS) diagram. Please refer to Fig.1. Fig.1 shows a related PDS diagram. The bandwidth BW and the frequency offset $F_{off}$ is estimated according to the following formulas:

$$BW = B - A$$

$$F_{off} = (B + A)/2$$

Wherein B and A are the corresponding positive and negative frequencies when the PDS value reaches half of the maximum. However, the accuracy of this estimated method varies with different channels. In an Additive White Gaussian Noise (AWGN) channel, the accuracy is adequate; in a multi-path or frequency-selective fading channel, the accuracy is poor since the PDS diagram varies with time.

**BRIEF SUMMARY OF THE INVENTION**

A detailed description is given in the following embodiments with reference to the accompanying drawings. An object of the invention is to provide a bandwidth and frequency offset estimation method comprising: comparing sample values of an input signal with at least one threshold value; estimating a plurality of positive and/or negative frequencies corresponding to different threshold values; and determining a bandwidth and a frequency offset according to the plurality of positive and/or negative frequencies.

**BRIEF DESCRIPTION OF THE DRAWINGS**

The present invention can be more fully understood by reading the subsequent detailed description and examples with references made to the accompanying drawings, wherein:

Fig.1 shows a related PDS diagram of an input signal;

Fig.2 is a block diagram of a receiver according to an embodiment of the invention;

Fig.3 shows a block diagram of the estimation module in Fig.2;

Fig.4 shows a PDS diagram of the input time-domain signal.

**DETAILED DESCRIPTION OF THE INVENTION**

The following description is of the best-contemplated mode of carrying out the invention. This description is made for the purpose of illustrating the general principles of the invention and should not be taken in a limiting sense. The scope of the invention is best determined by reference to the appended claims.

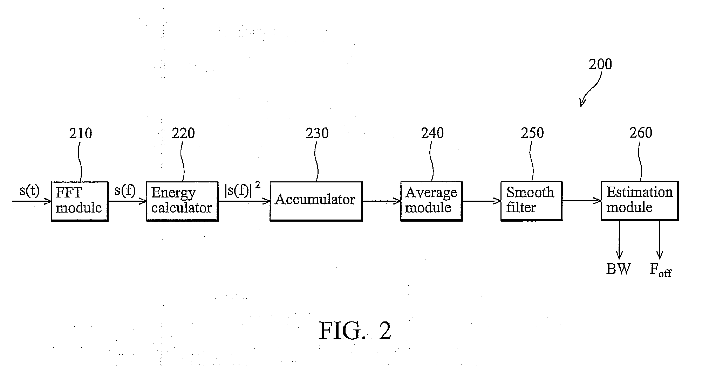

Please refer to Fig.2. Fig.2 is a block diagram of a receiver 200 according to an embodiment of the invention. The receiver comprises a Fast Fourier Transform (FFT) module 210, an energy calculator 220, an accumulator 230, an average module 240, a smooth filter 250, and an estimation module 260. The FFT module 210 converts an input time-domain signal s(t) to a frequency-domain signal s(f). The energy calculator 220 calculates the energy according to the frequency-domain signal s(f) to generate a power density spectrum (PDS) signal $|s(f)|^2$. Then the PDS signal $|S(f)|^2$ is sequentially accumulated, averaged, and smoothed by the accumulator 230, the average module 240, and the smooth filter 250 to generate a modified PDS signal $|s(f)|^2$. The estimation module 260 finally estimates the bandwidth BW and the frequency offset $F_{off}$ according to the modified PDS signal $|s(f)|^2$. A detailed description of the estimation module 260 is provided in the following.

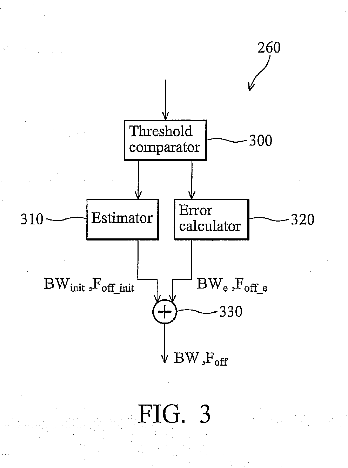

Please refer to Fig.3. Fig.3 shows a block diagram of the estimation module 260 in Fig.2. The estimation module 260 comprises a threshold comparator 300, an estimator 310, an error calculator 320, and a compensator 330. The threshold comparator 300 compares a plurality of sample values of the PDS signal $|s(f)|^2$ with threshold values. The estimator 310 performs a coarse estimation according to the comparison result to generate a coarse bandwidth $BW_{init}$ and the coarse frequency offset $F_{off\_init}$. The error calculator 320 calculates a compensating bandwidth value $BW_e$ and a compensating frequency offset value $F_{off\_e}$. Finally the compensator 330 (e.g. an adder) compensates the coarse bandwidth $BW_{init}$ and the coarse frequency offset $F_{off\_init}$ to output the bandwidth BW and the frequency offset $F_{off}$ according to the compensating bandwidth value $BW_e$ and a compensating frequency offset value $F_{off\_e}$. A detailed description of the estimating process in provided in the following.

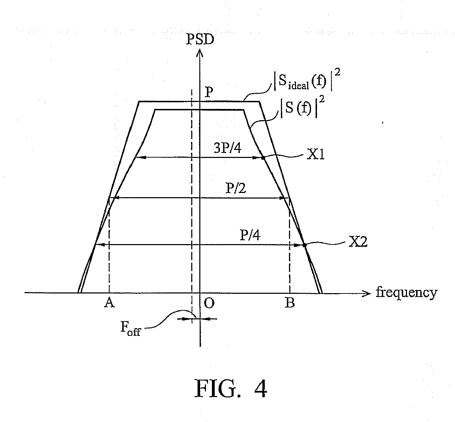

Please refer to Fig.4. Fig.4 shows a PDS diagram of the input time-domain signal s(t). The ideal PDS signal $|s_{ideal}(f)|^2$ is an ideal power signal shape transmitted from a transmitter (not shown) and the actual PDS signal $|s(f)|^2$ is a received power signal shape from the receiver 200. These two power shapes are always different due to a channel (not shown) between the transmitter and the receiver, especially a multi-path or frequency-selective fading channel. The bandwidth BW and the frequency offset $F_{off}$ can be estimated according to a plurality of threshold points. For example, if the values $\dfrac{1}{2}P$ and $\dfrac{1}{4}P$ are taken as the threshold values of the threshold comparator 300, the corresponding threshold points X1 and X2 is found in the realistic PDS signal $|s(f)|^2$. We can use a straight line passing through the points X1 and X2 and its slope to find the estimated positive frequency B. After the positive frequency B is found, the bandwidth BW and the frequency offset $F_{off}$ can also be determined. Additionally, the bandwidth BW and the frequency offset $F_{off}$ can be determined according to different slope from different threshold values (e.g. $\dfrac{1}{2}P$ , $\dfrac{1}{4}P$ and $\dfrac{1}{8}P$ ).

A further discussion is provided in the following.

The input time-domain signal s(t) is a band-pass signal as shown in the following:

$$s(t) = \mathrm{Re}\left[ v(t) e^{j 2 \pi f_c t} \right]$$

wherein v(t) is an equivalent low-pass signal. For example, if a quadrature amplitude modulation (QAM) is utilized in the receiver 200, the equivalent low-pass signal v(t) can be shown in the following:

$$v(t) = \sum_{-\infty}^{\infty} I_n g(t - nT)$$

wherein T is a symbol period, {In} is a complex symbol sequence, and g(t) is a shaped impulse. Taking a square-root raised cosine pulse as an example, the shaped impulse and its PDS signal is shown in the following:

$$g(t) = \frac{4\alpha}{\pi\sqrt{T}} \frac{\cos\left[\frac{(1+\alpha)\pi t}{T}\right] + \frac{T}{4\alpha t}\sin\left[\frac{(1-\alpha)\pi t}{T}\right]}{1 - \left(\frac{4\alpha t}{T}\right)^2}$$

$$|G(f)|^2 = \begin{cases} 1, 0 \le |f| < \frac{1-\alpha}{2T} \\ \frac{1}{2}\left[1 + \sin\frac{\pi}{\alpha}\left(\frac{1}{2} - |f|T\right)\right], \frac{1-\alpha}{2T} \le |f| < \frac{1+\alpha}{2T} \\ 0, |f| \ge \frac{1+\alpha}{2T} \end{cases}$$

wherein $\alpha$ is a roll-off factor. The PDS signal $|s(f)|^2$ is obtained by multiplying $|G(f)|^2$ and a constant. The threshold values are shown in the following:

$$\text{threshold}_1 = \frac{\max + \min}{2} = \frac{P + 0}{2} = \frac{P}{2}$$

$$\text{threshold}_2 = \frac{\text{threshold}_1 + \min}{2} = \frac{\max + 3*\min}{4} = \frac{P + 3*0}{4} = \frac{P}{4}$$

wherein P is the maximum value of the PDS signal $|s(f)|^2$. In an ideal channel (e.g. AWGN channel), only the threshold value $\text{threshold}_1$ is utilized and the positive frequencies k1 and k2 can be determined by comparing each value of the PDS signal $|s(f)|^2$ with the threshold value $\text{threshold}_1$. If a plurality of continuous values of the PDS signal $|s(f)|^2$ are larger than the threshold value $\text{threshold}_1$, the positive frequency k1 is then determined in the range of the plurality of continuous values. If a plurality of continuous values of the PDS signal $|s(f)|^2$ are less than the threshold value $\text{threshold}_1$, then the positive frequency k2 is determined in the range of the plurality of continuous values. Then the bandwidth BW and the frequency offset $F_{off}$ is estimated according to the following formulas:

$$BW = (k2 - k1)*\frac{F_s/2}{256} \quad (Mbps)$$

$$F_{off} = \left(\frac{k2 + k1}{2} - 128\right)*\frac{F_s/2}{256} \quad (MHz)$$

wherein $F_s$ is a sampling IF frequency. In a multi-path or frequency-selective fading channel, the shape of the PDS signal $|s(f)|^2$ always varies and the accuracy of the above-mentioned estimation formula only utilizing one threshold value is poor. Hence an additional threshold value ($\text{threshold}_2$) is utilized to estimate the bandwidth BW and the frequency offset $F_{off}$. Similarly, the positive frequencies k3 and k4 corresponding to the threshold value $\text{threshold}_2$ can be determined in a range of the plurality of continuous values, respectively. If the value ( ( k4 - k3 ) - ( k2 - k1 ) ) is less then the value ($\text{threshold}_1$ - $\text{threshold}_2$), the bandwidth BW and the frequency offset $F_{off}$ are still estimated according to the above-mentioned formula; Otherwise, they are estimated according to the following formulas:

$$BW = (k4 - k3 + \frac{(k4 - k3) - (k2 - k1)}{8}) * \frac{F_s/2}{256} \quad (Mbps)$$

$$F_{off} = (\frac{k4 + k3}{2} - 128) * \frac{F_s/2}{256} \quad (MHz)$$

Compared with the related art, the bandwidth and frequency estimation method of the invention has a higher accuracy in different channels. Additionally, under a low frequency resolution (FFT length), the estimation method of the invention can still work properly.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

**Claims**

1.  A bandwidth and frequency offset estimation method comprising:

    comparing sample values of an input signal with at least one threshold value;
    estimating a plurality of positive and/or negative frequencies corresponding to different threshold values; and
    determining a bandwidth and a frequency offset according to the plurality of positive and/or negative frequencies.

2.  The bandwidth and frequency offset estimation method as claimed in claim 1, wherein the input signal is a power density spectrum (PDS) signal.

3.  The bandwidth and frequency offset estimation method as claimed in claim 2, wherein a threshold number is equal to one and the threshold value is equal to half of a maximum value of the PDS signal.

4.  The bandwidth and frequency offset estimation method as claimed in claim 3, wherein the step of estimating frequencies further comprises:

    determining a first positive frequency k1 in a range of a plurality of continuous values of the PDS signal, wherein the plurality of continuous values are larger then the threshold value; and
    determining a second positive frequency k2 in a range of a plurality of continuous values of the PDS signal, wherein the plurality of continuous values are less then the threshold value.

5.  The bandwidth and frequency offset estimation method as claimed in claim 4, wherein the bandwidth BW and the frequency offset $F_{off}$ is estimated according to the following formulas:

$$BW = (k2 - k1) * \frac{F_s/2}{256}$$

$$F_{off} = (\frac{k2 + k1}{2} - 128) * \frac{F_s/2}{256}$$

6.  The bandwidth and frequency offset estimation method as claimed in claim 2, wherein a threshold number is equal to two, a first threshold value is equal to half of a maximum value of the PDS signal, and a second threshold value is equal to one quarter of the maximum value of the PDS signal.

7. The bandwidth and frequency offset estimation method as claimed in claim 6, wherein the step of estimating frequencies further comprises:

   determining a first positive frequency k1 in a range of a plurality of continuous values of the PDS signal corresponding to the first threshold value, wherein the plurality of continuous values is larger than the threshold value;
   determining a second positive frequency k2 in a range of a plurality of continuous values of the PDS signal corresponding to the first threshold value threshold$_1$, wherein the plurality of continuous values is less than the threshold value threshold$_2$;
   determining a first positive frequency k3 in a range of a plurality of continuous values of the PDS signal corresponding to the second threshold value, wherein the plurality of continuous values is larger than the threshold value; and
   determining a second positive frequency k4 in a range of a plurality of continuous values of the PDS signal corresponding to the second threshold value, wherein the plurality of continuous values is less than the threshold value.

8. The bandwidth and frequency offset estimation method as claimed in claim 7, wherein the bandwidth BW and the frequency offset $F_{off}$ is estimated according to the following formulas if a value ( ( k4 - k3 ) - ( k2 - k1 ) ) is less than the value (threshold$_1$ - threshold$_2$):

$$BW = (k2 - k1) * \frac{F_s/2}{256}$$

$$F_{off} = (\frac{k2 + k1}{2} - 128) * \frac{F_s/2}{256}$$

9. The bandwidth and frequency offset estimation method as claimed in claim 7, wherein the bandwidth BW and the frequency offset $F_{off}$ is estimated according to the following formulas if a value ( ( k4 - k3 ) - ( k2 - k1 ) ) is larger than the value (threshold$_1$ - threshold$_2$):

$$BW = (k4 - k3 + \frac{(k4 - k3) - (k2 - k1)}{8}) * \frac{F_s/2}{256} \quad (Mbps)$$

$$F_{off} = (\frac{k4 + k3}{2} - 128) * \frac{F_s/2}{256} \quad (MHz)$$

10. The bandwidth and frequency offset estimation method as claimed in claim 2, wherein a threshold number is equal to a limited value, a first threshold value is equal to half of a maximum value of the PDS signal, a second threshold value is equal to half of the first threshold value, a third threshold value is equal to half of the second threshold value, etc...

**Amended claims in accordance with Rule 137(2) EPC.**

1. A bandwidth and frequency offset estimation method comprising:

   comparing sample values of an input signal with at least one threshold value;
   estimating a coarse bandwidth value and a coarse frequency offset according to a result of comparing sample values;
   calculating a compensating bandwidth value and a compensating frequency offset value according to the result of comparing sample values; and

determining a bandwidth and a frequency offset according to the coarse bandwidth value, the coarse frequency offset, the compensating bandwidth value and the compensating frequency offset value.

**2.** The bandwidth and frequency offset estimation method as claimed in claim 1, wherein the input signal is a power density spectrum (PDS) signal.

**3.** The bandwidth and frequency offset estimation method as claimed in claim 2, wherein a threshold number is equal to one and the threshold value is equal to half of a maximum value of the PDS signal.

**4.** The bandwidth and frequency offset estimation method as claimed in claim 3, wherein the step of comparing sample values further comprises:

determining a first positive frequency k1 in a range of a plurality of continuous values of the PDS signal, wherein the plurality of continuous values are larger then the threshold value; and
determining a second positive frequency k2 in a range of a plurality of continuous values of the PDS signal, wherein the plurality of continuous values are less then the threshold value.

**5.** The bandwidth and frequency offset estimation method as claimed in claim 4, wherein the bandwidth BW and the frequency offset $F_{off}$ is estimated according to the following formulas:

$$BW = (k2 - k1) * \frac{F_s/2}{N}$$

$$F_{off} = (\frac{k2 + k1}{2} - \frac{N}{2}) * \frac{F_s/2}{N}$$

Where N is the length of fast furrier transform (FFT), and N determining the resolution of PDS. Such as, N is 256, 512,1024,etc.,

**6.** The bandwidth and frequency offset estimation method as claimed in claim 2, wherein a threshold number is equal to two, a first threshold value is equal to half of a maximum value of the PDS signal, and a second threshold value is equal to one quarter of the maximum value of the PDS signal.

**7.** The bandwidth and frequency offset estimation method as claimed in claim 6, wherein the step of comparing sample values further comprises:

determining a first positive frequency k1 in a range of a plurality of continuous values of the PDS signal corresponding to the first threshold value $threshold_1$, wherein the plurality of continuous values is larger than the first threshold value $threshold_1$;
determining a second positive frequency k2 in a range of a plurality of continuous values of the PDS signal corresponding to the first threshold value $threshold_1$, wherein the plurality of continuous values is less than the first threshold value $threshold_1$;
determining a first positive frequency k3 in a range of a plurality of continuous values of the PDS signal corresponding to the second threshold value $threshold_2$, wherein the plurality of continuous values is larger than the second threshold value $threshold_2$; and
determining a second positive frequency k4 in a range of a plurality of continuous values of the PDS signal corresponding to the second threshold value thresholds, wherein the plurality of continuous values is less than the second threshold value $threshold_2$.

**8.** The bandwidth and frequency offset estimation method as claimed in claim 7, wherein the bandwidth BW and the frequency offset $F_{off}$ is estimated according to the following formulas if a value ( ( k4 - k3 ) - ( k2 - k1) ) is less than the value ($threshold_1$ - $threshold_2$):

$$BW = (k2 - k1) * \frac{F_s/2}{N}$$

$$F_{off} = (\frac{k2 + k1}{2} - \frac{N}{2}) * \frac{F_s/2}{N}$$

Where N is the length of FFT, and N determining the resolution of PDS. Such as, N is 256, 512,1024, etc.,

**9.** The bandwidth and frequency offset estimation method as claimed in claim 7, wherein the bandwidth BW and the frequency offset $F_{off}$ is estimated according to the following formulas if a value ( ( k4 - k3 ) - ( k2 - k1 )) is larger than the value (threshold$_1$ - threshold$_2$):

$$BW = (k4 - k3 + \frac{(k4 - k3) - (k2 - k1)}{8}) * \frac{F_s/2}{N}$$

$$F_{off} = (\frac{k4 + k3}{2} - 128) * \frac{F_s/2}{N}$$

Where N is the length of FFT, and N determining the resolution of PDS. Such as, N is 256, 512,1024,etc.,

**10.** The bandwidth and frequency offset estimation method as claimed in claim 2, wherein a threshold number is equal to a limited value, a first threshold value is equal to half of a maximum value of the PDS signal, a second threshold value is equal to half of the first threshold value, a third threshold value is equal to half of the second threshold value, etc..

FIG. 1 (RELATED ART)

200

210   220   230   240   250   260

s(t) → | FFT module | s(f) → | Energy calculator | $|s(f)|^2$ → | Accumulator | → | Average module | → | Smooth filter | → | Estimation module |

BW   $F_{off}$

FIG. 2

FIG. 3

FIG. 4

**European Patent Office**

**DECLARATION**

which under Rule 45 of the European Patent Convention shall be considered, for the purposes of subsequent proceedings, as the European search report

Application Number

EP 06 11 5309

| The Search Division considers that the present application, does not comply with the provisions of the EPC to such an extent that it is not possible to carry out a meaningful search into the state of the art on the basis of all claims<br><br>Reason:<br><br>Claim 1 is directed to a method comprising the step of:<br>"estimating a plurality of positive and/or negative frequencies corresponding to different threshold values".<br>further, the bandwidth and the frequency offset are determined "according to the plurality of positive and/or negative frequencies" determined in the mentioned step.<br><br>It is objected (see Art. 84 EPC, Guidelines C-III, 6.3-6.4) that the description does not support this broad solution to the subjective problem stated in the application (increase of the accuracy of the bandwidth determination in a multi-path selective fading channel).<br>Rather:<br>- the description provides only for a single method of determining the bandwidth and the frequency offset on the base of an estimate of a plurality of positive and/or negative frequencies, and<br>- the examiner raises doubts that other estimations would provide a solution to the mentioned problem.<br><br>Further, with reference to the single method disclosed for estimating a plurality of positive and/or negative frequencies,<br><div align="right">-/--</div> | **CLASSIFICATION OF THE APPLICATION (IPC)**<br><br>INV.<br>G01R23/16 |

| Place of search | Date | Examiner |
|---|---|---|
| Berlin | 13 November 2006 | Farese, Luca |

**European Patent**
**Office**

## DECLARATION

which under Rule 45 of the European Patent Convention shall be considered, for the purposes of subsequent proceedings, as the European search report

**Application Number**

EP 06 11 5309

| The Search Division considers that the present application, does not comply with the provisions of the EPC to such an extent that it is not possible to carry out a meaningful search into the state of the art on the basis of all claims | **CLASSIFICATION OF THE APPLICATION (IPC)** |
|---|---|
| Reason:<br><br>attention is drawn on paragraph [0024]. In this paragraph it is disclosed that: "the positive frequency k1 is then determined in the range of the plurality of continuous values", further "the positive frequency k2 is determined in the range of the plurality of continuous values". These expressions are not understandable and do not provide searchable and determined values which could be compared to a prior art. In conclusion, the application does not allow the skilled man in the art to determine (Art. 83 EPC) which are the values of k1 and k2, necessary to carry out the invention (i.e. the steps of lines 5, 6 of claim 1, corresponding to the calculations of paragraph [0025]).<br><br>The applicant's attention is drawn to the fact that a search may be carried out during examination following a declaration of no search under Rule 45 EPC, should the problems which led to the declaration being issued be overcome (see EPC Guideline C-VI, 8.5).<br><br>-----| |

| Place of search | Date | Examiner |
|---|---|---|
| Berlin | 13 November 2006 | Farese, Luca |